Europäisches Patentamt

European Patent Office

Office européen des brevets

(19)

(11) **EP 0 593 007 B1**

(12) **EUROPÄISCHE PATENTSCHRIFT**

(45) Veröffentlichungstag und Bekanntmachung des Hinweises auf die Patenterteilung:
**23.03.2005 Patentblatt 2005/12**

(51) Int Cl.$^7$: **G01R 27/18**

(21) Anmeldenummer: **93116488.3**

(22) Anmeldetag: **12.10.1993**

(54) **Verfahren zum Bestimmen der elektrischen Netzableitung in ungeerdeten elektrischen Netzen**

Method of determining electric leakage in unearthed electric networks

Procédé de détermination de la fuite électrique dans des réaux non mis à la terre

(84) Benannte Vertragsstaaten:
**AT BE CH DE FR GB LI NL SE**

(30) Priorität: **15.10.1992 DE 4234808**

(43) Veröffentlichungstag der Anmeldung:
**20.04.1994 Patentblatt 1994/16**

(73) Patentinhaber: **DIPL.-ING. W. BENDER GmbH & Co. KG**
**35301 Grünberg (DE)**

(72) Erfinder: **Hackl, Dieter**
**35463 Fernwald (DE)**

(74) Vertreter: **Schumacher, Bernd, Dipl.-Ing.**
**Am Schwaberg 13**
**63454 Hanau (DE)**

(56) Entgegenhaltungen:
**EP-A- 0 061 704        EP-A- 0 398 824**
**DE-A- 2 717 158        DE-A- 3 941 975**
**US-A- 4 528 497        US-A- 4 638 242**

**EP 0 593 007 B1**

## Beschreibung

Verfahren zum Bestimmen der elektrischen Netzableitung in ungeerdeten elektrischen Netzen.

Die Erfindung betrifft ein Verfahren zum Bestimmen der zwischen Netz und Erde von ungeerdeten elektrischen Netzen wirksamen elektrischen Netzableitung, wobei eine Meßsignaleinspeisung zwischen Netz und Erde erfolgt, wobei der Netzableitungsstrom, der aufgrund der Meßsignaleinspeisung über die Netzableitung zwischen Netz und Erde fließt, einen Spannungsabfall hervorruft und wobei dieser Spannungsabfall als Ausgangssignal zur Bestimmung der Netzableitung ausgewertet wird

Bei dem Verfahren gemäß der US-A-4 528497 wird im Rahmen der sog. LIM Meßtechnik die gesamte Netzableitung als Impedanz (Admittanz) von ungeerdeten Netzen bei Netzfrequenz ermittelt, um daraus den maximal gefährdenden Ableitstrom zu bestirnmen. Die ohmschen und kapazitiven Netzableitgrößen werden nicht einzeln erfaßt. Die Netzfrequenz muß bekannt sein und geht in die Berechnung ein. Es werden hierbei zwei Meßfrequenzen benutzt, die keine gegenseitige harmonische Abhängigkeiten aufweisen dürfen. Eine Verwendung von mehr als zwei Meßfrequenzen ist zwar möglich, wird jedoch nicht empfohlen und führt nur zur Erzeugung überflüssiger redundanter Informationen.

Bei einem für reine Wechselstromnetze dienenden bekannten Verfahren der genannten Art wird dem Netz als Meßsignalspannung über eine ohmsche Netzankopplung eine Meßgleichspannung überlagert. Diese Meßsignalspannung erzeugt einen über die Netzankopplung und die Netzableitung fließenden Netzableitungsstrom. Das dadurch an der Netzankopplung abfallende Gleichspannungs-Ausgangssignal dient als Maß für den ohmschen Erdschlußwiderstand der Netzableitung.

Wenn jedoch im Wechselstromnetz Umrichter, Wechselrichter, Frequenzumrichter, Stromrichter oder dergleichen vorhanden sind, ergeben sich Störgrößen, wie überlagerte, gegensinnige Gleichspannungsanteile. Für solche Wechselstromnetze wurde das bekannte Pulscode-Verfahren entwickelt, bei dem eine Meßperiode aus zwei Meßtakten besteht, nämlich einem solchen mit einer überlagerten Meßgleichspannung und einem solchen ohne Spannungsüberlagerung. Die vorhandene Netzableitkapazität muß zuvor mit anderen Maßnahmen ermittelt und dann bei dem Verfahren berücksichtigt werden. Durch Differenzbildung der Meßergebnisse können Störgrößen und damit verbundene Fehlmessungen unterdrückt werden. Dadurch kann der ohmsche Erdschlußwiderstand der Netzableitung zuverlässig bestimmt werden. Erhebliche Probleme entstehen jedoch dann, wenn im Netz beispielsweise bei Regelvorgängen von Umrichtern niederfrequente Änderungen von störenden Gleichspannungsanteilen auftreten.

Der vorliegenden Erfindung liegt die Aufgabe zugrunde, ein Verfahren der im Oberbegriff von Anspruch 1 genannten Art so auszubilden, daß eine zuverlässige, einfache Erfassung der einzelnen Netzableitgrößen, nämlich des ohmschen Erdschlußwiderstands und der Netzableitkapazität, ohne Kenntnis der Netzfrequenz in beliebigen Netzen möglich ist. Dieses soll selbst dann zutreffen, wenn die Netze niederfrequente Störkomponenten aufweisen.

Zur Lösung der gestellten Aufgabe zeichnet sich ein Verfahren zum Bestimmen der elektrischen Netzableitung in ungeerdeten elektrischen Netzen der im Oberbegriff von Anspruch 1 genannten Art erfindungsgemäß durch die im Kennzeichen dieses Anspruchs aufgeführten Merkmale aus.

Ein solches Verfahren läßt sich relativ einfach bei beliebigen Netzen durchführen und führt auch dann zu guten Ergebnissen, wenn sich auf dem Netz niederfrequente Störungen befinden. Es ist nur erforderlich, geeignete Meßsignalfrequenzen zu wählen und genau einzuhalten, ferner die genannten Betragsquotienten genau zu bestimmen und die beiden Netzableitgrößen aus den festen Funktionszusammenhängen zu berechnen. Fehlerbehaftete bzw. durch übermäßige Störsignale verfälschte Meßergebnisse können leicht unterdrückt werden. Dabei sind die Meßsignalfrequenzen ausreichend klein zu wählen, damit die Einflüsse vorhandener, jedoch in ihrer Größe unbekannter Netzinduktivitäten vernachlässigt werden können und sich somit vergleichsweise einfache Funktionszusammenhänge ergeben. Diese Funktionszusammenhänge lassen sich in einfacher Weise speichern und bei jedem Meßvorgang mit den entsprechenden Meßsignalfrequenzen sowie Betragsquotienten schnell auswerten. Wenn die Amplituden der Meßsignale für die verschiedenen Meßvorgange eines jeden Meßzyklus oder auch mehrerer Meßzyklen -, zumindest vorübergehend, konstant gehalten werden, hängen die einzelnen Netzableitgrößen nur noch von den gemessenen zugeordneten Ausgangssignalen ab. Dabei ist es möglich, amplitudenkonstante Meßsignal-Wechselspannungen über eine Widerstands-Netzankopplung oder amplitudenkonstante Meßsignal-Wechselströme direkt in das zu überprüfende Netz einzuspeisen. Unterschiede ergeben sich dabei lediglich in der Art der Auswertung, da für diese Falle unterschiedliche Betragsquotienten und Funktionszusammenhänge gelten.

Die Weiterbildung von Anspruch 2 bezieht sich auf den speziellen Fall der Einspeisung amplitudenkonstanter Meßsignal-Wechselspannungen über eine Widerstands-Netzankopplung. Die angegebenen Näherungslösungen, die für vergleichsweise kleine Meßsignalfrequenzen unter Vernachlässigung der Netzinduktivitäten gelten, führen zu ausreichend genauen Meßergebnissen. Sie lassen sich einfach und schnell auswerten.

Die Weiterbildung von Anspruch 3 kann bei sinusförmigen Meßsignal-Wechselspannungen und Meßsignal-Wechselströmen insofern vorteilhaft sein, als dann für die Bestimmung der Betragsquotienten nur eines der Meßsignale amplitudenmäßig gemessen werden muß.

Während die Weiterbildung von Anspruch 4 eine einfache Trennung der Einzelmessungen eines jeden Meßvorganges ermöglicht und keine besonderen Anforderungen an den gegenseitigen Abstand der Meßsignalfrequenzen stellt, hat die Alternative von Anspruch 5 den Vorteil einer gleichzeitigen und somit schnelleren Auswertung.

Die Weiterbildung von Anspruch 6 ermöglicht eine wiederholte, wie eine ständige, Überwachung des Netzes. Da die Amplituden der Meßsignale und die Meßsignalfrequenzen in den verschiedenen Meßzyklen nicht verändert werden, entfällt ein ständiges neues Erfassen derselben. Dieses beschleunigt die Meß- und Berechnungsvorgange. Auch können die vorgegebenen bzw. unveränderlichen Amplituden und Meßsignalfrequenzen bereits in den Funktionszusammenhangen berücksichtigt sein, so daß nur noch die Amplituden der Ausgangssignale einzugeben sind.

Die Verwendung von Rechtecksignalen gemäß Anspruch 7 führt bei konstanter Störspannung und gleichem Effektivwert der Meßsignal-Wechselspannungen oder Meßsignal-Wechselströme zu einem Störabstandsgewinn von 5 dB allein aufgrund der Wahl der Rechteckkurvenform. Die meßtechnische Auswertung der Grundwellen ist vorteilhaft, weil die Amplituden der Oberwellen sehr viel kleiner sind. Liegt jedoch eine Oberwelle in einem wenig gestörten Frequenzbereich, dann kann auch deren Auswertung sinnvoll sein.

Die Weiterbildung von Anspruch 8 ermöglicht eine sehr genaue Bestimmung der Netzableitgrößen auf schmalbandige Weise, weil die Meßsignalfrequenzen mikrocontrollergesteuert sehr genau eingehalten werden können.

Gemäß Anspruch 9 sind verschiedene Auswertungen der Ausgangssignale möglich. Bei einer Auswertung von Grund- und Oberwellen ist ein Einsatz der schnellen Fouriertransformation vorteilhaft, da diese jeweils nur einmal durchgeführt werden muß, während beispielsweise bei einer rekursiven oder nicht rekursiven digitalen Filterung für die Grund- und Oberwellen je ein Berechnungsdurchlauf erforderlich ist.

Gemäß Anspruch 10 lassen sich auch die Auswertungen der Ausgangssignale mikrocontrollergesteuert und somit sehr genau durchführen.

Die Weiterbildungen der Ansprüche 11 bis 14 beinhalten vorteilhafte praktische Ausgestaltungen des Verfahrens. Demnach liegen die Meßsignalfrequenzen deutlich unter der Netzfrequenz, Je kleiner die Meßsignalfrequenzen sind, desto kleiner sind die Einflüsse der zu vernachlässigenden Netzinduktivitäten und desto größer ist die Genauigkeit der Meßergebnisse. Die Genauigkeit und die Signalabtastrate der Analog/Digital-Wandlung der Ausgangssignale beeinflussen die Signalauflösung und die Güte der Filtermaßnahmen. Die Ausgestaltung von Anspruch 14 ermöglicht bei Verlängerung der Meßzeiten die Verwendung langsamerer und somit einfacherer und preiswerterer Wandler.

Die Maßnahme von Anspruch 15 dient der Vorbereitung des Meßvorgangs, damit bereits die ersten Meßergebnisse ausreichend genau sind.

Die Maßnahme von Anspruch 16 ermöglicht eine wiederholte Überprüfung dahingehend, ob die Meßsignalfrequenzen in einem weitgehend ungestörten Frequenzbereich liegen, und eine entsprechende Frequenzveränderung im Bedarfsfalle.

Die Weiterbildung von Anspruch 17 ermöglicht eine besonders schnelle wiederholte Meßauswertung, da lediglich noch die Betrage der Ausgangssignale, als Teil der Betragsquotienten, erfaßt und in die festen Funktionszusammenhänge einzusetzen sind.

Die weitere Ausgestaltung von Anspruch 18 ist immer dann sinnvoll, wenn keine maßgeblichen Änderungen der Netzableitkapazität erwarten werden, was bei Netzen konstanter Ausdehnung normalerweise der Fall ist. Auch diese Maßnahme beschleunigt den Meßzyklus.

Die Erfindung wird nachfolgend an zwei zeichnerisch dargestellten Ausführungsbeispielen näher erläutert. Es zeigen:

Fig. 1     ein erstes Ausführungsbeispiel mit einer Einspeisung amplitudenkonstanter Meßsignal-Wechselspannungen über eine ohmsche Netzankopplung und

Fig. 2     ein zweites Ausführungsbeispiel mit einer Einspeisung amplitudenkonstanter Meßsignal-Wechselströme.

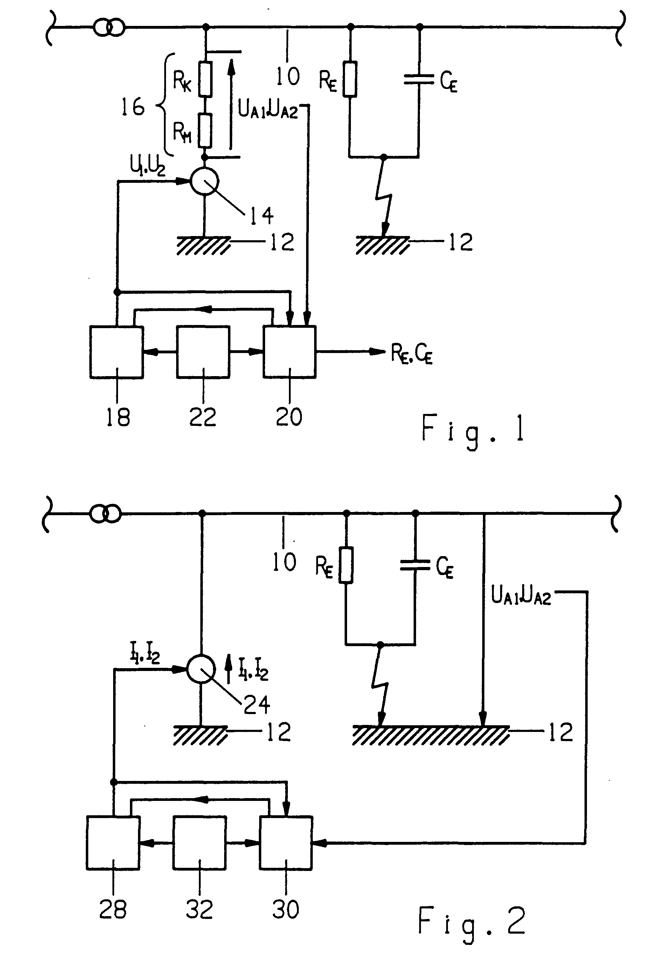

Demnach weist gemäß den Figuren 1 und 2 ein beliebiges ungeerdetes elektrisches Netz 10 unvermeidbare Netzableitgrößen auf, nämlich einen Erdschlußwiderstand $R_E$ und eine Netzableitkapazität $C_E$ zur Erde 12.

Gemäß Figur 1 dient eine Einspeisung 14 zum aufeinanderfolgenden Einspeisen von mehr als zwei amplitudenkonstanten Meßsignal-Wechselspannungen $U_1$, $U_2$... mit festen Meßsignalfrequenzen $f_1$, $f_2$ und ist über eine Netzankopplung 16 zwischen das Netz 10 und Erde 12 geschaltet. Die Netzankopplung besteht aus einem hochohmigen ohmschen Ankoppelwiderstand $R_K$ und einem hierzu in Reihe geschalteten ohmschen Meßwiderstand $R_M$. Statt der an der gesamten Netzankopplung 16 anstehenden und auszuwertenden Ausgangssignale $U_{A1}$, $U_{A2}$ können grundsätzlich auch die am Meßwiderstand $R_M$ abfallenden Ausgangssignale ausgewertet werden.

Die Einspeisung 14 ist an ein Steuergerät 18 angeschlossen, von dem die Meßsignal-Wechselspannungen $U_1$, $U_2$... mit den Meßsignalfrequenzen $f_1$, $f_2$... und den Amplituden $U_{01}$, $U_{02}$ zugeführt werden. Die Meßsignal-Wechselspannungen und die Ausgangssignale $U_{A1}$, $U_{A2}$ werden gleichzeitig einer filternden und berechnenden Auswerteeinrichtung 20 zugeführt, die hieraus die Betragsquotienten K, = $U_{01}$ / $U_{A1}$, K2 = $U_{02}$ / $U_{A2}$ ... bildet und mittels der Meßsignalfrequenzen $f_1$, $f_2$ ... aus in der Auswerteeinrichtung 20 gespeicherten Funktionszusammenhängen die Netzableitgrößen $R_E$ und $C_E$ bestimmt. Ein an das Steuergerät 18 und die Auswerteeinrichtung 20 angeschlossener Mikrocontroller 22 sorgt für einen ordnungsgemäßen Funktionsablauf. Im vorliegenden Fall ist die Auswerteinrichtung 20 zusätzlich an einen Eingang des Steuergerätes 18 angeschlossen, damit die Meßsignalfrequenzen bedarfsgerecht angepaßt und in störungsarme Bereiche gelegt werden können.

Gemäß Figur 2 dient eine Einspeisung 24 zum aufeinanderfolgenden Einspeisen von mehr als zwei amplitudenkonstanten Meßsignal-Wechselströmen $I_1$, $I_2$,... mit festen Meßsignalfrequenzen $f_1$, $f_2$.... Die Einspeisung 24 ist direkt zwischen das Netz 10 und Erde 12 geschaltet. Die Ausgangssignale $U_{A1}$, $U_{A2}$ werden als Spannung zwischen Netz 10 und Erde 12 erfaßt, also an der Parallelschaltung von $R_E$ und $C_E$ gemessen.

Der Einspeisung 24 ist an ein Steuergerät 28 angeschlossen, von dem die Meßsignal-Wechselströme $I_1$, $I_2$... mit den Meßsignalfrequenzen $f_1$, $f_2$... und den Amplituden $I_{01}$, $I_{02}$... zugeführt werden. Die Meßsignal-Wechselströme und die Ausgangssignaie $U_{A1}$, $U_{A2}$ ... werden gleichzeitig einer filternden und berechnenden Auswerteeinrichtung 30 zugeführt, die hieraus die Betragsquotienten $K_1$ = $I_{01}$ / $U_{A1}$, K2 = $I_{02}$ / $U_{A2}$ ... bildet und mittels der Meßsignalfrequenzen $f_1$, $f_2$ ... aus in der Auswerteeinrichtung 30 gespeicherten Funktionszusammenhängen die Netzableitgrößen $R_E$ und $C_E$ bestimmt. Ein an das Steuergerät 28 und die Auswerteeinrichtung 30 angeschlossener Mikrocontroller 32 sorgt für einen ordnungsgemäßen Funktionsablauf. Im vorliegenden Fall ist die Auswerteinrichtung 30 zusätzlich an einen Eingang des Steuergerätes 28 angeschlossen, damit die Meßsignalfrequenzen bedarfsgerecht angepaßt und in störungsarme Bereiche gelegt werden können.

Wenn bei Netzen gleichbleibender Ausdehnung eine im wesentlichen gleichbleibende Netzableitkapazität vorliegt, muß diese nicht ständig wieder neu bestimmt werden. Eine laufende Netzüberwachung beschränkt sich dann im wesentlichen auf ein wiederholtes Bestimmen des Erdschlußwiderstandes.

Die in der Auswerteeinrichtung 20 bzw. 34 gespeicherten festen Funktionszusammenhänge stellen Bestimmungsgleichungen für die Netzableitgrößen dar. Bei Vernachlässigung des Einflusses der Netzinduktivitäten ergeben diese Bestimmungsgleichungen Näherungswerte für die Netzableitgrößen. Für das Ausführungsbeispiel aus Figur 1 sind sehr brauchbare, die Netzinduktivitäten vernachlässigende Funktionszusammenhänge bzw. Bestimmungsgleichungen in Patentanspruch 2 aufgeführt.

Bei einer Einspeisung von amplitudenkonstanten Meßsignal-Wechselspannungen gemäß Figur 1 haben sich folgende, die Netzinduktivitäten vernachlässigende Näherungslösungen für die Funktionszusammenhänge als praktikabel erwiesen:

$$R_E = \frac{Ri}{\sqrt{K_x^2 + K_x} + K_x}$$

$$K_x = \frac{1}{K_1^2 - 1} - \frac{\omega_1^2}{\omega_2^2 - \omega_1^2} \cdot \left[ \frac{1}{K_2^2 - 1} - \frac{1}{K_1^2 - 1} \right]$$

$$C_E = \frac{1}{Ri} \sqrt{\frac{\left(2 \cdot \frac{Ri}{R_E} + 1\right)\left[\frac{K_1^2 - 1}{K_2^2 - 1} - 1\right]}{(\omega_2^2 - \omega_1^2) \cdot (K_1^2 - 1)}}$$

Die darin genannten Größen haben folgende Bedeutung:

Ri = $R_K$ + $R_M$ — Gesamtwiderstand der ohmschen Netzankopplung
$\omega_1$ = 2 π $f_1$ ; $\omega_2$ = 2 π $f_2$ — $f_1$, $f_2$ Meßsignalfrequenzen
$K_1$ = $U_{01}$ / $U_{A1}$ ; $K_2$ = $U_{02}$ / $U_{A2}$ — $U_{01}$, $U_{02}$ Meßsignalamplituden
$U_{A1}$, $U_{A2}$ Ausgangssignalamplituden

**Patentansprüche**

1. Verfahren zum Bestimmen der zwischen Netz und Erde von ungeerdeten elektrischen Netzen wirksamen elektrischen Netzableitung, wobei eine Meßsignaleinspeisung zwischen Netz und Erde erfolgt, wobei der Netzableitungsstrom, der aufgrund der Meßsignaleinspeisung über die Netzableitung zwischen Netz und Erde fließt, einen Spannungsabfall hervorruft und wobei dieser Spannungsabfall als Ausgangssignal zur Bestimmung der Netzableitung ausgewertet wird.
**dadurch gekennzeichnet**,

   a) daß bei der Meßsignaleinspeisung mehr als zwei amplitudenkonstante, periodische Meßsignal-Wechselspannungen oder mehr als zwei amplitudenkonstante, periodische Meßsignal-Wechselströme eingespeist werden, die voneinander sowie von der Netzfrequenz ($f_N$) abweichende, gegenüber dieser kleine und in störungsarmen Frequenzbereichen liegende Meßsignalfrequenzen ($f_1$, $f_2$...) aufweisen,

   b) daß für jede der verschiedenen Meßsignalfrequenzen ein Betragsquotient ($K_1$, $K_2$...) bestimmt wird, wobei

      b1) im Falle von einzuspeisenden Meßsignal-Wechselspannungen diese über eine Widerstands-Netzankopplung in das Netz eingespeist werden und wobei jeweils der Betragsquotient zwischen den Spannungsamplituden der Grundwellen oder der einander zugeordneten Oberwellen der Meßsignal-Wechselspannung und des an der Widerstands-Netzankopplung auftretenden Ausgangssignals bestimmt wird, während
      b2) im Falle von einzuspeisenden Meßsignal-Wechselströmen diese ohne Widerstands-Netzankopplung direkt in das Netz eingespeist werden und wobei jeweils der Betragsquotient zwischen der Stromamplitude der Grundwelle des Meßsignal-Wechselsstroms und der Spannungsamplitude der Grundwelle des zwischen Netz und Erde auftretenden Ausgangssignals bestimmt wird oder der Betragsquotient zwischen einer Oberwellen des Meßsignal-Wechseisstroms und der Spannungsamplitude der zugeordneten Oberwelle des zwischen Netz und Erde auftretenden Ausgangssignals bestimmt wird,

   c) daß aus von der Netzfrequenz ($f_N$) unabhängigen festen Funktionszusammenhängen, die jeweils von zwei Meßsignalfrequenzen ($f_1$, $f_2$ ...) und den zugehörigen zwei Betragsquotienten ($K_1$, $K_2$ ...) abhängen, die ohmschen und kapazitiven Netzableitgrößen ($R_E$, $C_E$) der Netzableitung bestimmt werden, wobei die Netzinduktivitäten vernachlässigt sind und wobei durch Vergleich der für die verschiedenen Meßsignalfrequenzen ($f_1$, $f_2$ ...) erhaltenen Meßergebnisse festgestellte störsignalbehaftete Meßsignalfrequenzen ausgeschaltet werden, indem sie nach ihrer Feststellung nicht mehr verwendet werden.

2. Verfahren nach Anspruch 1, **dadurch gekennzeichnet, daß** bei Einspeisung von amplitudenkonstanten Meßsignal-Wechselspannungen die Netzableitgrößen aus folgenden Funktionszusammenhängen bestimmt werden:

$$R_E = \frac{R_i}{\sqrt{K_x^2 + K_x} + K_x}$$

$$K_x = \frac{1}{K_1^2 - 1} - \frac{\omega_1^2}{\omega_2^2 - \omega_1^2} \cdot \left[ \frac{1}{K_2^2 - 1} - \frac{1}{K_1^2 - 1} \right]$$

$$C_E = \frac{1}{R_i} \sqrt{\frac{\left( 2 \cdot \frac{R_i}{R_E} + 1 \right) \left[ \frac{K_1^2 - 1}{K_2^2 - 1} - 1 \right]}{(\omega_2^2 - \omega_1^2) \cdot (K_1^2 - 1)}}$$

Ri Gesamtwiderstand der ohmschen Netzankopplung

$\omega_1 = 2\,\pi\,f_1$ ; $\omega_2 = 2\,\pi\,f_2$      $f_1$ , $f_2$ Meßsignalfrequenzen

$K_1 = U_{01}/U_{A1}$ ; $K_2 = U_{02} / U_{A2}$      $U_{01}$, $U_{02}$ Meßsignalamplituden

                                       $U_{A1}$, $U_{A2}$ Ausgangssignalamplituden

3. Verfahren nach Anspruch 1 oder 2, **dadurch gekennzeichnet, daß** die Amplituden der Grundwellen oder Oberwellen der mehr als zwei Meßsignal-Wechselspannungen oder Meßsignal-Wechselströme gleich groß gewählt werden.

4. Verfahren nach einem der Ansprüche 1 bis 3, **dadurch gekennzeichnet, daß** die mehr als zwei Meßsignal-Wechselspannungen oder Meßsignal-Wechselströme für jeden Meßvorgang nacheinander eingespeist werden.

5. Verfahren nach einem der Ansprüche 1 bis 3, **dadurch gekennzeichnet, daß** die mehr als zwei Meßsignal-Wechselspannungen oder Meßsignal-Wechselstrome für jeden Meßvorgang gleichzeitig eingespeist werden.

6. Verfahren nach Anspruch 4 oder 5, **dadurch gekennzeichnet, daß** mehrere Meßzyklen mit unveränderten Amplituden der Meßsignale und unveränderten Meßfrequenzen nacheinander durchgeführt werden.

7. Verfahren nach einem der Ansprüche 1 bis 6, **dadurch gekennzeichnet, daß** als Meßsignal-Wechselspannungen oder Meßsignal-Wechselströme Rechtecksignale benutzt und die Amplituden der Grundwellen derselben sowie der Ausgangssignale schmalbandig erfaßt werden.

8. Verfahren nach einem der Ansprüche 1 bis 7, **dadurch gekennzeichnet, daß** mikrocontrollergesteuerte Meßsignalfrequenzen ($f_1$, $f_2$ ...) verwendet werden.

9. Verfahren nach einem der Ansprüche 1 bis 8, **dadurch gekennzeichnet, daß** die Ausgangssignale zur Gewinnung der Grundwellen oder beliebiger Oberwellen digital gefiltert oder einer schnellen Fourier-Transformation unterworfen werden.

10. Verfahren nach Anspruch 9, **dadurch gekennzeichnet, daß** die Filterung oder Fourier-Transformation der Ausgangssignale mikrocontrollergesteuert schmalbandig durchgeführt wird.

11. Verfahren nach einem der Ansprüche 1 bis 10, **dadurch gekennzeichnet, daß** bei einer Netzfrequenz ($f_N$) von 50 Hz Meßsignalfrequenzen ($f_1$, $f_2$...) in der Größenordnung von etwa 1 Hz verwendet werden.

**12.** Verfahren nach einem der Ansprüche 1 bis 11, **dadurch gekennzeichnet, daß** die Ausgangssignale einer 24 Bit oder einer 17 Bit Analog/Digital-Wandlung unterworfen werden.

**13.** Verfahren nach Anspruch 12, **dadurch gekennzeichnet, daß** für die Analog/Digital-Wandlung der Ausgangssignale eine Signalabtastrate von ca. 1024 Punkten pro Signalperiode vorgesehen wird.

**14.** Verfahren nach Anspruch 12, **dadurch gekennzeichnet, daß** für die Analog/Digital-Wandlung der Ausgangssignale eine Signalabtastrate von ca. 32 Punkten pro Signalperiode und eine durchgehende Abtastung über jeweils 32 Signalperioden vorgesehen werden.

**15.** Verfahren nach einem der Ansprüche 1 bis 14, **dadurch gekennzeichnet, daß** vor Einspeisung von Meßsignalen zunächst eine schnelle Fouriertransformation der auf dem Netz befindlichen Signale durchgeführt wird und die Meßsignalfrequenzen ($f_1$, $f_2$) so gewählt werden, daß sie in einem weitgehend störsignalfreien Bereich liegen.

**16.** Verfahren nach einem der Ansprüche 1 bis 15, **dadurch gekennzeichnet, daß** in gewissen Zeitabständen oder ständig drei Meßsignalfrequenzen eingespeist werden, daß die so erhaltenen momentanen Meßergebnisse untereinander und/oder mit älteren Meßergebnissen verglichen werden und daß beim Vorliegen zu großer Meßdifferenzen die Meßsignalfrequenzen für die zukünftigen Meßvorgänge entsprechend verändert werden.

**17.** Verfahren nach einem der Ansprüche 1 bis 16, **dadurch gekennzeichnet, daß** die festen Funktionszusammenhänge in Verbindung mit in diese bereits eingesetzen, jedoch veränderbaren, Vorgaben für die verschiedenen Meßsignalamplituden und für die verschiedenen Meßsignalfrequenzen gespeichert werden.

**18.** Verfahren nach einem der Ansprüche 1 bis 17, **dadurch gekennzeichnet, daß** bei Netzen gleichbleibender Ausdehnung der Erdschlußwiderstand wiederholt bestimmt und überwacht wird.

**Claims**

**1.** Method for determining the active electric leakage between network and earth on unearthed electric networks, a measuring signal being supplied between network and earth, the leakage current, flowing between network and earth via the leakage on the basis of the measuring signal supply, creating a voltage drop and this voltage drop being used as an output signal for the determination of the leakage,
**characterised in that**

a) more than two periodic measuring signal alternating voltages with constant amplitudes or more than two periodic measuring signal alternating currents with constant amplitudes are supplied during the measuring signal supply, which have measuring signal frequencies ($f_1$, $f_2$) that are different from each other and from the network frequency ($f_N$) with frequency ranges that are relatively small and not subject to much interference,

b) a sum quotient ($K_1$, $K_2$...) is determined for each of the various measuring signal frequencies, wherein

b1) in the case of measuring signal alternating voltages, these are supplied into the network via a resistive network coupling and wherein the respective sum quotient between the voltage amplitudes of the fundamental waves or the corresponding harmonic waves of the measuring signal alternating current and the output signal occurring at the resistive network coupling is determined, whilst
b2) in the case of measuring signal alternating currents, these are supplied directly into the network without a resistive network coupling and wherein the sum quotient between the current amplitude of the fundamental wave of the measuring signal alternating current and the voltage amplitude of the fundamental wave of the output signal arising between the network and earth is determined or the sum quotient between a fundamental wave of the measuring signal alternating current and the voltage amplitude of the corresponding fundamental wave of the output signal occurring between the network and earth is determined,

c) the resistive and capacitive leakage values ($R_E$, $C_E$) of the leakage are determined from the fixed formulae that are independent of the network frequency ($f_N$), that depend on two measuring signal frequencies ($f_1$, $f_2$...) and the associated two sum quotients (($K_1$, $K_2$...) respectively, the network inductance being ignored and by comparison of the values received for the various measuring signal frequencies ($f_1$, $f_2$...) established measuring signal frequencies which contain interference can be excluded, **in that** they are not used any more after establishment thereof.

2. Method according to claim 1, **characterised in that**, during the supply of measuring signal alternating voltages with constant amplitudes, the volumes of leakage can be determined from the following formulae:

$$R_E = \frac{R_i}{\sqrt{K_x^2 + K_x} + K_x}$$

$$K_x = \frac{1}{K_1^2 - 1} - \frac{\omega_a^2}{\omega_2^2 - \omega_1^2} \cdot \left[ \frac{1}{K_2^2 - 1} - \frac{1}{K_1^2 - 1} \right]$$

$$C_E = \frac{1}{R_i} \sqrt{\frac{\left(2 \cdot \frac{R_i}{R_E} + 1\right) \left[ \frac{K_1^2 - 1}{K_2^2 - 1} - 1 \right]}{(\omega_2^2 - \omega_1^2) \cdot (K_1^2 - 1)}}$$

Ri total resistance of the resistive network coupling

$\omega_1 = 2\Pi f_1$ ; $\omega_2 = 2\Pi f_2$      $f_1$, $f_2$ measuring signal frequency
$K_1 = U_{01} / U_{A1}$; $K2 = U_{02} / U_{A2}$      $U_{01}$, $U_{02}$ measuring signal amplitudes
                                    $U_{A1}$, $U_{A2}$ output signal amplitudes

3. Method according to either claims 1 or 2, **characterised in that** the amplitudes of the fundamental waves or the harmonic waves of the measuring signal alternating voltages or measuring signal alternating currents of which there are more than two can be selected to be exactly the same.

4. Method according to any one of claims 1 to 3, **characterised in that** the measuring signal alternating voltages or measuring signal alternating currents of which there are more than two are supplied one after the other for each measuring process.

5. Method according to any one of claims 1 to 3, **characterised in that** the measuring signal alternating voltages or measuring signal alternating currents of which there are more than two are supplied at the same time for each measuring process.

6. Method according to claim 4 or 5, **characterised in that** a plurality of measuring cycles with unchanged amplitudes of measuring signals and unchanged measuring frequencies are carried out one after the other.

7. Method according to any one of claims 1 to 6, **characterised in that** rectangular signals are used as measuring signal alternating voltages or measuring signal alternating currents and the amplitudes of the fundamental waves of the same and the output signals are recorded in narrow band.

8. Method according to any one of claims 1 to 7, **characterised in that** measuring signal frequencies ($f_1$, $f_2$) are used that are controlled by a microcontroller.

9. Method according to any one of claims 1 to 8, **characterised in that** the output signals are digitally filtered to obtain the fundamental waves or any harmonic waves to suit or are subjected to a quick Fourier transform.

10. Method according to claim 9, **characterised in that** the filtering or Fourier transform of the output signals controlled by a microcontroller are carried out in narrow band.

**11.** Method according to any one of claims 1 to 10, **characterised in that** measuring signal frequencies ($f_1$, $f_2$) in the region of about 1 Hz are used at a network frequency ($f_N$) of 50 Hz.

**12.** Method according to any one of claims 1 to 11, **characterised in that** the output signals are subject to a 24 bit or a 17 bit analogue-digital conversion.

**13.** Method according to claim 12, **characterised in that** a signal scan rate of approximately 1024 points per signal period is used for the analogue-digital conversion of the output signals.

**14.** Method according to claim 12, **characterised in that** a signal scan rate of approximately 32 points per signal period and a continuous scanning for approximately 32 signal periods is used for the analogue-digital conversion of the output signals.

**15.** Method according to any one of claims 1 to 14, **characterised in that** a quick Fourier transform is performed on the signals on the network first before the supply of measuring signals and the measuring signal frequencies ($f_1$, $f_2$) are selected so that they lie in a predominantly interference free region.

**16.** Method according to any one of claims 1 to 15, **characterised in that** three measuring signal frequencies are supplied at certain time intervals or continuously, so that the instantaneous measured results thus obtained are compared with each other and/or with older measured results and when measuring differences are present which are too great then the measuring signal frequencies are altered accordingly for future measuring processes.

**17.** Method according to any one of claims 1 to 16, **characterised in that** the fixed formulae are saved in conjunction with the procedures, that are already in use but are changeable, for the various measuring signal amplitudes and for the various measuring signal frequencies.

**18.** Method according to any one of claims 1 to 17, **characterised in that** expansion of the earth leakage resistance which remains constant in networks is determined repeatedly and monitored.

**Revendications**

**1.** Procédé de détermination de la fuite électrique agissant entre le réseau et la terre dans des réseaux électriques non mis à la terre, une injection de signaux de mesure étant effectuée entre le réseau et la terre, le courant de fuite qui s'écoule en raison de l'injection des signaux de mesure à travers la fuite entre le réseau et la terre provoquant une chute de tension et cette chute de tension étant exploitée en tant que signal de sortie pour la détermination de la fuite électrique,
caractérisé en ce

a) que, lors de l'injection des signaux de mesure, plus de deux tensions alternatives de signaux de mesure périodiques d'amplitude constante ou plus de deux courants alternatifs de signaux de mesure périodiques d'amplitude constante sont injectés, qui présentent des fréquences de signaux de mesure ($f_1$, $f_2$ ...) s'écartant les unes des autres ainsi que de la fréquence de réseau ($f_N$), petits par rapport à cette dernière et situées dans des gammes de fréquences pauvres en parasites,

b) qu'un quotient absolu ($K_1$, $K_2$ ...) est déterminé pour chacune des différentes fréquences de signaux de mesure,

b1) dans le cas de tensions alternatives de signaux de mesure à injecter, ces dernières étant injectées dans le réseau par un couplage de réseau ohmique et le quotient absolu entre les amplitudes de tension des ondes fondamentales ou des ondes harmoniques mutuellement associées de la tension alternative des signaux de mesure et du signal de sortie apparaissant sur le couplage de réseau ohmique étant à chaque fois déterminé, tandis que
b2) dans le cas de courants alternatifs de signaux de mesure à injecter, ces derniers sont injectés directement dans le réseau sans couplage de réseau ohmique, et le quotient absolu entre l'amplitude de courant de l'onde fondamentale du courant alternatif du signal de mesure et l'amplitude de tension de l'onde fondamentale du signal de sortie apparaissant entre le réseau et la terre étant à chaque fois déterminé ou le quotient absolu entre une onde harmonique du courant alternatif du signal de mesure et l'amplitude de tension de l'onde harmonique associée du signal de sortie apparaissant entre le réseau et la terre est déterminé,

c) en ce que les grandeurs de fuite ohmiques et capacitives ($R_E$, $C_E$) de la fuite électrique sont déterminées à partir de relations fonctionnelles fixes indépendantes de la fréquence du réseau ($f_N$), qui dépendent chacune de deux fréquences de signaux de mesure ($f_1$, $f_2$ ...) et des deux quotients absolus ($K_1$, $K_2$ ...) correspondants, les inductances de réseau étant négligées et des fréquences de signaux de mesure entachées de signaux parasites, mises en évidence par comparaison des résultats de mesure obtenus pour les différentes fréquences de signaux ($f_1$, $f_2$ ...), étant éliminées en n'étant plus utilisées après leur mise en évidence.

2. Procédé suivant la revendication 1, **caractérisé en ce que**, lors de l'injection de tensions alternatives de signaux de mesure d'amplitude constante, les grandeurs de fuite électrique sont déterminées à partir des relations fonctionnelles suivantes :

$$R_E = \frac{R_i}{\sqrt{K_x^2 + K_x} + K_x}$$

$$K_x = \frac{1}{K_1^2 - 1} - \frac{\omega_1^2}{\omega_2^2 - \omega_1^2} \cdot \left[ \frac{1}{K_2^2 - 1} - \frac{1}{K_1^2 - 1} \right]$$

$$C_E = \frac{1}{R_i} \sqrt{ \frac{\left( 2 \cdot \frac{R_i}{R_E} + 1 \right) \left[ \frac{K_1^2 - 1}{K_2^2 - 1} - 1 \right]}{(\omega_2^2 - \omega_1^2) \cdot (K_1^2 - 1)} }$$

Ri résistance totale du couplage de réseau ohmique

$\omega_1 = 2\pi f_1$ ; $\omega_2 = 2\pi f_2$   $f_1$, $f_2$ fréquences des signaux de mesure
$K_1 = U_{O1}/U_{A1}$ ; $K_2 = U_{O2}/U_{A2}$   $U_{O1}$, $U_{O2}$ amplitudes des signaux de mesure
$U_{A1}$, $U_{A2}$ amplitudes des signaux de sortie

3. Procédé suivant l'une des revendications 1 et 2, **caractérisé en ce que** les amplitudes des ondes fondamentales ou des ondes harmoniques des plus de deux tensions alternatives de signaux de mesure ou courants alternatifs de signaux de mesure sont choisies de même grandeur.

4. Procédé suivant l'une des revendications 1 à 3, **caractérisé en ce que** les plus de deux tensions alternatives de signaux de mesure ou courants alternatifs de signaux de mesure sont injectés successivement pour chaque opération de mesure.

5. Procédé suivant l'une des revendications 1 à 3, **caractérisé en ce que** les plus de deux tensions alternatives de signaux de mesure ou courant alternatifs de signaux de mesure sont injectés simultanément pour chaque opération de mesure.

6. Procédé suivant l'une des revendications 4 et 5, **caractérisé en ce que** plusieurs cycles de mesure sont mis en oeuvre successivement avec des amplitudes inchangées des signaux de mesure et des fréquences de mesure inchangées.

7. Procédé suivant l'une des revendications 1 à 6, **caractérisé en ce qu'**on utilise des signaux rectangulaires comme tensions alternatives de signaux de mesure ou courants alternatifs de signaux de mesure, et qu'on détecte en bande étroite les amplitudes des ondes fondamentales de ces derniers ainsi que les signaux de sortie.

8. Procédé suivant l'une des revendications 1 à 7, **caractérisé en ce qu'**on utilise des fréquences de signaux de mesure ($f_1$, $f_2$ ...) commandées par microcontrôleur.

9. Procédé suivant l'une des revendications 1 à 8, **caractérisé en ce que** les signaux de sortie sont filtrés numériquement ou soumis à une transformation de Fourier rapide pour l'obtention des ondes fondamentales ou d'ondes harmoniques quelconques.

10. Procédé suivant la revendication 9, **caractérisé en ce que** le filtrage ou la transformation de Fourier des signaux de sortie est réalisée en bande étroite avec commande par microcontrôleur.

11. Procédé suivant l'une des revendications 1 à 10, **caractérisé en ce qu'**on utilise des fréquences de signaux de mesure ($f_1$, $f_2$ ...) de l'ordre de grandeur d'environ 1 Hz pour une fréquence de réseau ($f_N$) de 50 Hz.

12. Procédé suivant l'une des revendications 1 à 11, **caractérisé en ce que** les signaux de sortie sont soumis à une conversion analogique/numérique de 24 chiffres binaires ou 17 chiffres binaires.

13. Procédé suivant la revendication 12, **caractérisé en ce qu'**une vitesse de balayage des signaux d'environ 1024 points par période de signal est prévu pour la conversion analogique/numérique des signaux de sortie.

14. Procédé suivant la revendication 12, **caractérisé en ce qu'**une vitesse de balayage des signaux d'environ 32 points par période de signal et un balayage continu sur 32 périodes à chaque fois sont prévus pour la conversion analogique/numérique des signaux de sortie.

15. Procédé suivant l'une des revendications 1 à 14, **caractérisé en ce qu'**une transformation de Fourier rapide des signaux présents sur le réseau est d'abord effectuée avant l'injection de signaux de mesure et que les fréquences des signaux de mesure ($f_1$, $f_2$ ...) sont choisies de telle sorte qu'elles se situent dans une gamme largement exempte de signaux parasites.

16. Procédé suivant l'une des revendications 1 à 15, **caractérisé en ce que** trois fréquences de signaux de mesure sont injectées à certains intervalles ou en permanence, que les résultats de mesure momentanés ainsi obtenus sont comparés entre eux et/ou à des résultats de mesure plus anciens et que, en présence de différences de mesure trop grandes, les fréquences des signaux sont modifiées en conséquence pour les opérations de mesure futures.

17. Procédé suivant l'une des revendications 1 à 16, **caractérisé en ce que** les relations fonctionnelles fixes sont mémorisées en liaison avec des consignes déjà incluses dans ces dernières, mais modifiables, pour les différentes amplitudes de signaux de mesure et pour les différentes fréquences de signaux de mesure.

18. Procédé suivant l'une des revendications 1 à 17, **caractérisé en ce que** la résistance de mise à la terre pour des réseaux d'extension constante est déterminée et surveillée de façon répétée.

Fig. 1

Fig. 2